(19) Europäisches Patentamt / European Patent Office / Office européen des brevets

(11) **EP 4 657 010 A1**

(12) **EUROPEAN PATENT APPLICATION**
published in accordance with Art. 153(4) EPC

(43) Date of publication:
**03.12.2025 Bulletin 2025/49**

(21) Application number: **24770385.3**

(22) Date of filing: **16.02.2024**

(51) International Patent Classification (IPC):
**G01B 11/00** (2006.01)   **H01L 21/02** (2006.01)

(52) Cooperative Patent Classification (CPC):
**G01B 11/00; H01L 21/02**

(86) International application number:
**PCT/JP2024/005539**

(87) International publication number:
**WO 2024/190270 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.03.2023   JP 2023040047**

(71) Applicant: **Kobelco Research Institute, Inc.**
**Kobe-shi, Hyogo 651-0073 (JP)**

(72) Inventors:
• **NISHIDA, Hiroto**
  **Kobe-shi, Hyogo 651-2271 (JP)**
• **FURUTA, Yohei**
  **Kobe-shi, Hyogo 651-2271 (JP)**

(74) Representative: **Müller-Boré & Partner**
**Patentanwälte PartG mbB**
**Friedenheimer Brücke 21**
**80639 München (DE)**

(54) **DEVICE AND METHOD FOR MEASURING POSITIONAL DISPLACEMENT AMOUNT OF LAMINATED SUBSTRATE, AND SEMICONDUCTOR MANUFACTURING DEVICE**

(57)    The present invention is to bonded substrates misalignment amount measurement device and method for measuring a misalignment amount between two sorts of disc-shaped substrates having different diameter from one another and including a first substrate and a second substrate lying one on another in a thickness direction thereof, and emit measurement light to the bonded substrates in the thickness direction to measure a transmission intensity distribution of the measurement light in a radial direction thereof, and calculate a misalignment amount on the basis of a measurement result. The measurement light has a wavelength enabling transmission through the one of the first substrate and the second substrate that has a larger diameter. The bonded substrates misalignment amount measurement device is used for a semiconductor manufacturing apparatus according to the present invention.

FIG.1

## Description

### Technical Field

The present invention relates to a bonded substrates misalignment amount measurement device and a misalignment amount measurement method for measuring a misalignment amount between two sorts of substrates lying one on another in a thickness direction, and a semiconductor manufacturing apparatus by use of the bonded substrates misalignment amount measurement device.

### Background Art

There have been recently known, for example, bonded substrates including a plurality of substrates lying one on another and bonded to one another in a thickness direction to execute a plurality of functions. For example, there are bonded substrates including a silicon (Si) substrate and a quartz substrate (glass substrate), bonded substrates including a silicon carbide (SiC) substrate and a silicon substrate, and bonded substrates including a sapphire substrate and a silicon substrate. For these substrates, it is required to bond them in a desired position. Thus, measurement of a bonding misalignment amount has been demanded to determine whether the substrates are bonded to each other in a desired position. For example, Patent Literature 1 discloses a bonded substrates misalignment detection device as a technology of measuring a misalignment amount in bonding.

The bonded substrates misalignment detection device disclosed in Patent Literature 1 is a device that detects a misalignment amount between two sorts of disc-shaped substrates lying one on another in a vertical direction, and includes: outermost edge measurement means (contour measurement means 3 as an example thereof) that detects an entire contour of the two sorts of bonded substrates; edge end position measurement means (edge shape measurement means 4 as an example thereof) that measures a relative radial irregularity in an outer circumferential end at a plurality of locations in a circumferential direction of the bonded substrates, and measures a relative edge end positional relationship between circumferential edges of the two sorts of substrates; and calculation means that calculates a misalignment amount between the two sorts of substrates by detecting contour data of one substrate from a result of the detection by the outermost edge measurement means, calculating contour data of the another substrate using the contour data of the one substrate as a reference and on the basis of the relative edge end positional relationship between the two sorts of substrates measured by the edge end position measurement means, and comparing the respective contour data of the two sorts of substrates with one another.

There is a case that the bonded substrates include a first substrate having a relatively large diameter and a second substrate having a relatively small diameter. In a case of measuring a misalignment amount in bonded substrates including a first substrate and a second substrate having a relatively large difference in size with each other, e.g., a 4-inch SiC substrate and an 8-inch Si substrate, the bonded substrates misalignment detection device disclosed in Patent Literature 1 is required to increase the size of the edge end position measurement means (the edge shape measurement means 4 as an example thereof) to capture an image of both end portions of the first substrate and the second substrate. This causes the entire size of the device to increase. Additionally, the edge end position measurement means is required to perform image processing to thereby obtain a difference between radii of the substrates at each of the measurement locations along the circumferential direction. This increases the amount of information to be processed for the calculation of a misalignment amount.

### Citation List

### Patent Literature

Patent Literature 1: Japanese Patent No. 5373707

### Summary of Invention

The present invention has been made in view of the circumstances described above, and an object thereof is to provide a bonded substrates misalignment amount measurement device and a misalignment amount measurement method that can suppress an increase in size of the entire device and an increase in amount of information to be processed, and a semiconductor manufacturing apparatus by use of the bonded substrates misalignment amount measurement device.

A bonded substrates misalignment amount measurement device and a misalignment amount measurement method according to the present invention are a device and a method for measuring a misalignment amount between two sorts of disc-shaped substrates having different diameter from one another and including a first substrate and a second substrate lying one on another in a thickness direction thereof. In the device and the method, measurement light is emitted to the bonded substrates in the thickness direction to measure a transmission intensity distribution of the measurement light in a radial direction thereof and calculate a misalignment amount on the basis of a measurement result. The measurement light has a wavelength enabling transmission through one of the first substrate and the second substrate that has a larger diameter. The bonded substrates misalignment amount measurement device is used for a semiconductor manufacturing apparatus according to the present invention.

The foregoing and other objects, features, and advantages of the present invention will be further understood by the following detailed description and accompanying drawings.

## Brief Description of Drawings

FIG. 1 is a block diagram showing a configuration of a bonded substrates misalignment amount measurement device according to an embodiment.
FIG. 2 is a schematic perspective view showing a measurement part and a turntable (an exemplary mover) in the bonded substrates misalignment amount measurement device.
FIG. 3 is diagrams showing a way of calculating contour data representing respective contours of a first substrate and a second substrate.
FIG. 4 is a graph showing an exemplary measurement result from a full rotation in a circumferential direction.
FIG. 5 is a graph showing the measurement result shown in FIG. 4 in polar coordinates.
FIG. 6 is a diagram showing a way of calculating a misalignment amount.
FIG. 7 is a flowchart showing an operation of the bonded substrates misalignment amount measurement device.

## Description of Embodiments

Hereinafter, one or more embodiments of the present invention will be described with reference to the accompanying drawings. However, the present invention should not be limited to the disclosed embodiments. Elements denoted by the same reference numerals in the drawings have the same configuration and repeated descriptions will be appropriately omitted. In the present specification, an element is denoted by a reference numeral having no subscript when being referred to collectively, while an element is denoted by a reference numeral having a subscript when being referred to individually.

A bonded substrates misalignment amount measurement device according to the embodiment is a device that measures a misalignment amount between two sorts of disc-shaped bonded substrates Ob including a first substrate Ob1 and a second substrate Ob2 lying one on another in a thickness direction thereof and having different sizes from one another. It should be noted that in the specification, one or both of the substrates may be a multilayer substrate, and "two sorts" is thus used instead of "two pieces". The above-mentioned disc shape includes not only a completely circular shape but also a circular shape having a cutout formed according to need, such as an orientation flat (flat), a notch, for example. In short, the disc shape is recognized to cover generally round shape. The bonded substrates misalignment amount measurement device includes a measurement part and a misalignment amount calculation part, wherein the measurement part emits measurement light to the bonded substrates in the thickness direction to thereby measure a transmission intensity distribution of the measurement light in a radial direction thereof, and the misalignment amount calculation part calculates a misalignment amount on the basis of a measurement result obtained by the measurement part. The measurement light is light that has a wavelength enabling transmission through the one of the first substrate and the second substrate that has a larger diameter than the other. Hereinafter, the bonded substrates misalignment amount measurement device and the bonded substrates misalignment amount measurement method performed by the device are more specifically described.

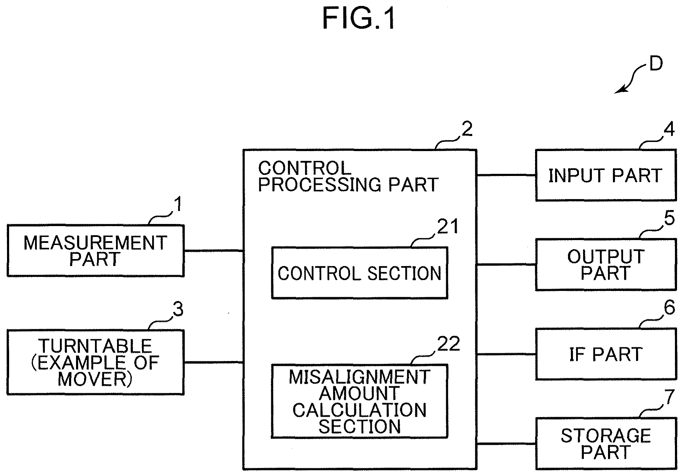

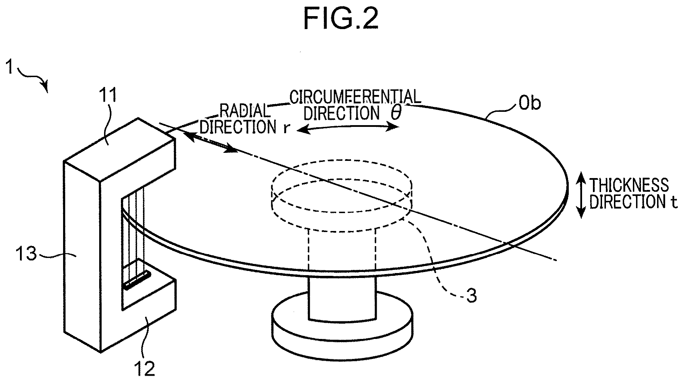

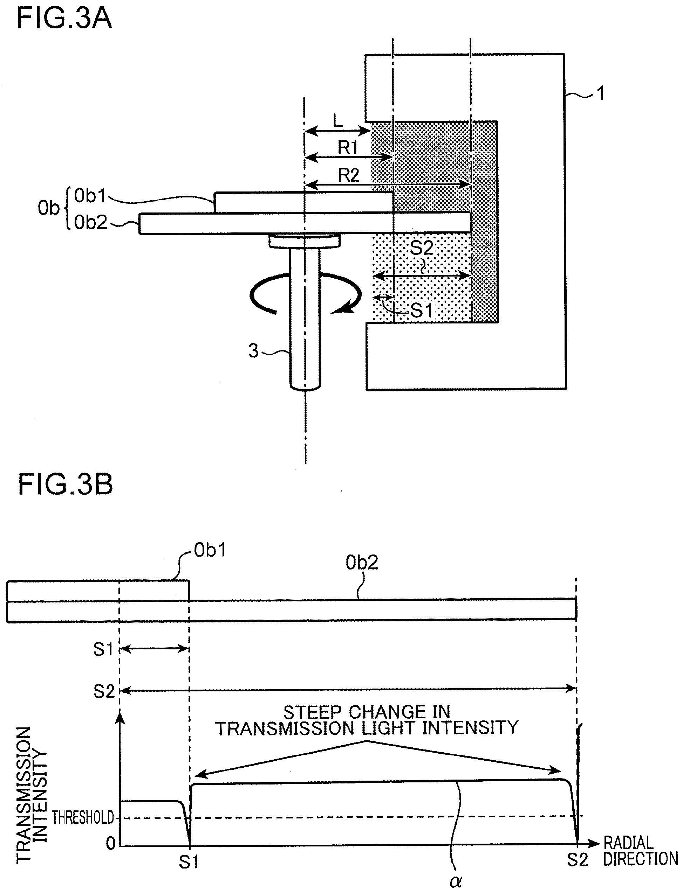

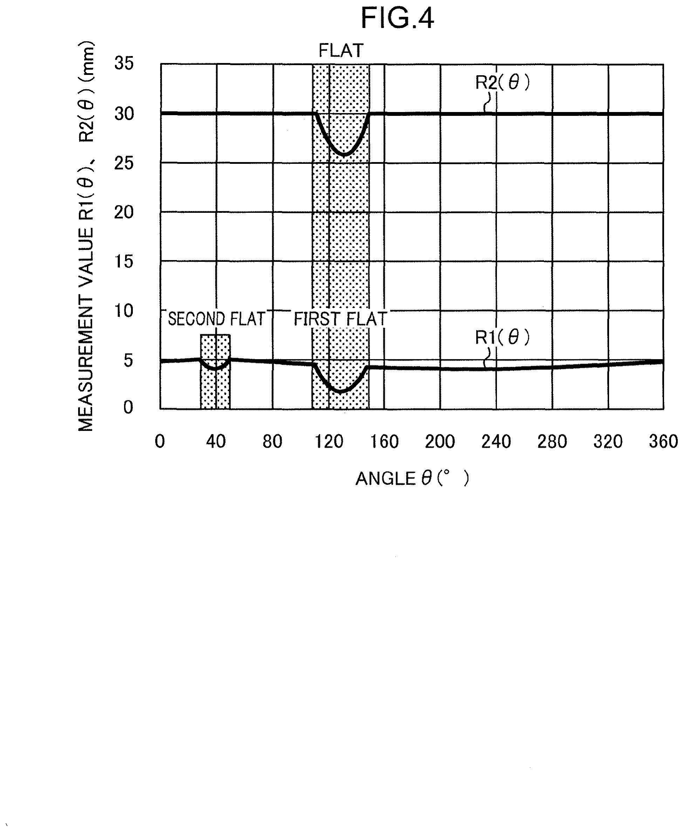

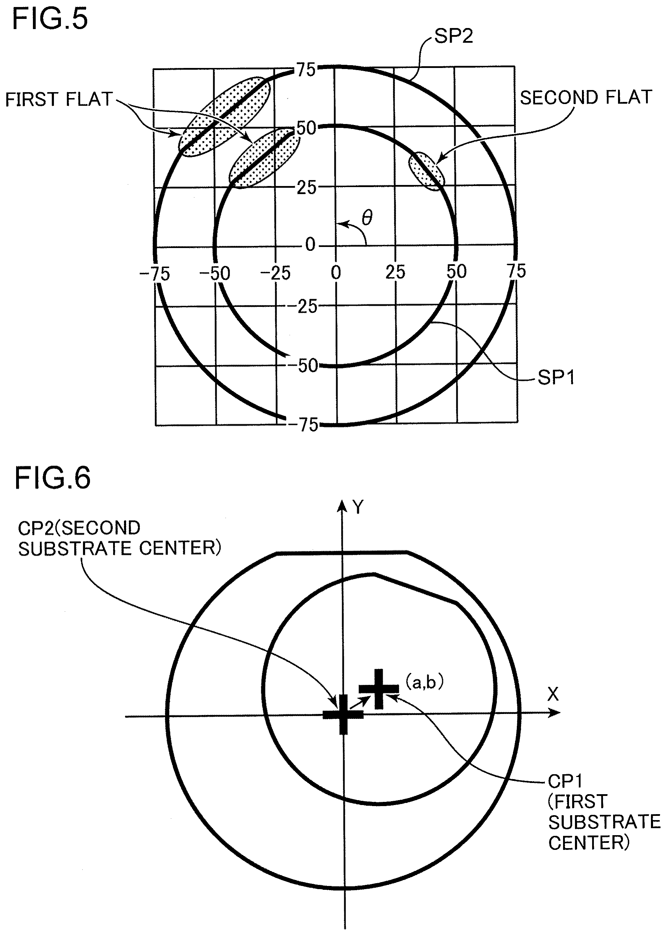

FIG. 1 is the block diagram showing the configuration of the bonded substrates misalignment amount measurement device according to the embodiment. FIG. 2 is the schematic perspective view showing the measurement part and the turntable (an exemplary mover) in the bonded substrates misalignment amount measurement device. FIG. 3 is the diagrams showing the way of calculating contour data representing respective contours of the first substrate and the second substrate. FIG. 3A is a side view showing a relationship between respective lengths of the parts. FIG. 3B shows a transmission intensity distribution curve in a radial direction as an exemplary measurement result. The horizontal axis in FIG. 3B represents positions in the radial direction, whereas the vertical axis represents a transmission intensity (measurement value). FIG. 4 is the graph showing exemplary measurement results from the full rotation in the circumferential direction. The horizontal axis in FIG. 4 represents locations in the circumferential direction, whereas the vertical axis represents a measurement value (transmission intensity). FIG. 5 is the graph showing the measurement results shown in FIG. 4 in polar coordinates. The X axis and the Y axis in FIG. 5 represent distances from a rotational center of the turntable. The measurement results shown in FIG. 4 are allocated along the X axis at a measurement start point of 0 [°], and then are plotted counter-clockwise. FIG. 6 is the diagram showing the way of calculating a misalignment amount.

The bonded substrates misalignment amount measurement device D according to the embodiment includes, for example, a measurement part 1, a control processing part 2, a turntable 3, an input part 4, an output part 5, an interface part (IF part) 6, and a storage part 7 as shown in FIG. 1 and FIG. 2.

The input part 4 is connected to the control processing part 2 and is adapted to input to the bonded substrates misalignment amount measurement device D various commands such as a command instructing a start of measurement, and various data necessary to operate the bonded substrates misalignment amount measurement device D such as a threshold Th to determine an end portion, and includes a keyboard, a mouse, and a plurality of input switches allotted with predetermined functions, for example. The output part 5 is connected to the control processing part 2 and is adapted to output the command input from the input part 4, data, a result of calculation, and the like under the control by the control processing part 2, and includes a display device such as a CRT display device, a liquid crystal display device (LCD), and an organic EL display device, and a printing device such as a printer, for example.

The input part 4 and the output part 5 may be constituted in a touch panel. In the configuration of the touch panel, the input part 4 includes a positional input device that senses an operational input position in a resistive or capacitive manner, and the output part 5 includes a display device, for example. In the touch panel, the positional input device is provided on a display screen of a display device. One or more inputtable candidate input contents are displayed on the display device. When a user touches a display position displayed with a desired input content, the positional input device detects the touched position. The display content displayed at the detected position is input to the bonded substrates misalignment amount measurement device D as an operational input content of the user. The touch panel allows a user to intuitively understand an input operation, and thus ensures provision of a bonded substrates misalignment amount measurement device D which can be easily handled by a user.

The IF part 6 includes a circuit that is connected to the control processing part 2 and is adapted to input and output data to and from an external device under the control by the control processing part 2, and includes, for example, an interface circuit of RS-232C which is a serial communication way, an interface circuit by use of the Bluetooth (registered trademark) standard, and an interface circuit by use of USB (Universal Serial Bus) standard. Alternatively, the IF part 6 may include a communication interface circuit that sends and receives a communication signal to and from an external device, such as a data communication card, or a communication interface circuit in conformity with IEEE 802. 11 standard.

The measurement part 1 is connected to the control processing part 2 and emits predetermined measurement light to bonded substrates Ob in (from) a thickness direction t of the bonded substrates Ob to thereby measure a transmission intensity distribution of the measurement light in a radial direction r of the bonded substrates Ob under the control by the control processing part 2. The measurement part 1 measures a transmission intensity distribution of the measurement light by emitting the measurement light to the bonded substrates Ob in the thickness direction t along a line extending in the radial direction r. The measurement part 1 measures a transmission intensity distribution of the measurement light at a plurality of measurement locations different from one another along a circumferential direction θ of the bonded substrates Ob.

For example, as shown in FIG. 2, the measurement part 1 includes a light emitting section 11 that emits the measurement light to the bonded substrates Ob in the thickness direction t along a line extending in the radial direction r, a light receiving section 12 that receives the measurement light emitted from the light emitting section 11 via the bonded substrates Ob, and a holding section 13 that holds the light emitting section 11 and the light receiving section 12 so as to face each other at a certain space therebetween. The light emitting section 11, the holding section 13, and the light receiving section 12 form a substantially C-shape in a side view (a shape of the letter E without the central horizontal bar "-"). Thus, the light receiving section 12 is arranged to face the light emitting section 11. The light emitting section 11 includes a device which transforms light radiated from a light source to parallel light via a collimating lens, passes the parallel light through a slit formed in a plate member and having a rectangular shape long in one direction to produce a slit light beam along the radial direction r, and emits the slit light beam to the bonded substrates Ob as the measurement light. The light receiving section 12 includes a line sensor or an area image sensor that is wider than the slit. The bonded substrates Ob is arranged in the measurement part 1 including the light emitting section 11 and the light receiving section 12 in such a manner that the radial direction r is along the one direction. Alternatively, for example, it may be appreciated that the light emitting section 11 is made to emit a laser beam irradiated from a light source to the bonded substrates Ob as the measurement light, and scan the laser beam along the radial direction r, while the light receiving section 12 includes a line sensor or an area image sensor that is wider than the laser beam. In the measurement part 1 including the light emitting section 11 and the light receiving section 12, the bonded substrates Ob is positioned in such a manner that the scanning direction is along the radial direction r. The holding section 13 includes, for example, a columnar member extending in a certain direction, and holds the light emitting section 11 and the light receiving section 12 on both end portions of the columnar member. The light emitting section 11 and the light receiving section 12 extend in a direction orthogonal to the certain direction.

The turntable 3 is connected to the control processing part 2, supports bonded substrates Ob, and allows the bonded substrates Ob to turn in the circumferential direction θ under the control by the control processing part 2. The turntable 3 is arranged with respect to the measurement part 1 in such a manner that the mounted bonded substrates Ob come between the light emitting section 11 and the light receiving section 12 of the measurement part 1. The turntable 3 allows the bonded substrates Ob to turn in the circumferential direction θ to thereby move the bonded substrates Ob with respect to the light emitting section 11 and the light receiving section 12 of the measurement part 1 in the circumferential direction. The turntable 3 is an exemplary moving mechanism that executes a relative movement in a circumferential direction between the light emitting section and the light receiving section and the bonded substrates placed between the light emitting section and the light receiving section. In this embodiment, the measurement part 1 is stationary and the bonded substrates Ob is moved by the turntable 3. However, it may appreciated that the bonded substrates Ob may be stationary and the measurement part 1 is moved with respect to the bonded substrates Ob, or the both are moved.

Further, in this embodiment, the measurement light has a wavelength enabling transmission through the one of the first substrate Ob1 and the second substrate Ob2 of the bonded substrates Ob that has a larger diameter. A transmittance rate of the bonded substrates Ob for the light having a wavelength enabling transmission is a value allowing the measurement part 1 to obtain a significant transmission intensity because a transmission intensity of the measurement light through the bonded substrates Ob is required to be measured at the measurement part 1. In other words, a transmittance rate of the bonded substrates Ob for the light having a wavelength enabling transmission is not required to be 100%, but is not zero. Further, the measurement light may be transmittable through both the first substrate Ob1 and the second substrate Ob2 of the bonded substrates Ob. However, the measurement light is not required to be transmittable through the both. As described above, it is sufficient that the measurement light transmits through at least the one of the substrates that has a larger diameter. In this embodiment, a substrate having a relatively small size is made of a material that shields the measurement light (in other words, a substrate having a relatively large size is made of a material that allows the measurement light to pass therethrough). Specifically, in a case where bonded substrates Ob include a second substrate Ob2 having a relatively large diameter and a first substrate Ob1 that has a relatively small diameter and lies on the second substrate Ob2 in the thickness direction t, the first substrate Ob1 is made of a material that shields the measurement light.

For the measurement light, light having a wavelength suitable for material of bonded substrates Ob to be measured is used. For example, in a case where the one of the first substrate Ob1 and the second substrate Ob2 of the bonded substrates Ob that has a larger diameter is an SiC substrate, the measurement light is visible green light having a wavelength of 505 [nm] to 555 [nm]. For example, a green light emitting diode (green LED) emitting green light is used in the light emitting section 11. A silicon photodiode is used in the light receiving section 12. Alternatively, for example, in a case where the one of the first substrate Ob1 and the second substrate Ob2 of the bonded substrates Ob that has a larger diameter is a Si substrate, the measurement light is infrared light having a wavelength of 3 [μm] to 16 [μm]. For example, a quantum cascade laser (QCL) or an interband cascade laser (ICL) that emits an infrared laser beam is used in the light emitting section 11. An MCT (HgCdTe) infrared detector is used in the light receiving section 12. Alternatively, for example, in a case where the one of the first substrate Ob1 and the second substrate Ob2 of the bonded substrates Ob that has a larger diameter is a glass substrate, the measurement light is light from ultraviolet light to infrared light that has a wavelength of 200 [nm] to 3000 [nm]. For example, various semiconductor laser elements that emit a laser beam having a central wavelength of 375 [nm] to 2000 [nm] are used in the light emitting section 11. A silicon photodiode is used in the light receiving section 12.

The storage part 7 includes a circuit that is connected to the control processing part 2 and stores various predetermined programs and various kinds of predetermined data under the control by the control processing part 2. The various predetermined programs include, for example, a control processing program. The control processing program includes, for example, a control program for controlling the parts 1, 3 to 7 of the bonded substrates misalignment amount measurement device D according to functions of the respective parts, and a misalignment amount calculation program for calculating a misalignment amount in bonded substrates on the basis of the measurement result obtained by the measurement part 1. The various kinds of predetermined data include data necessary to execute each program, such as a measurement result by the measurement part 1 and various kinds of calculation results in the process of calculations. The storage part 7 includes, for example, a read only memory (ROM) that is a nonvolatile storage element, an electrically erasable programmable read only memory (EEPROM) that is a rewritable nonvolatile storage element, or the like. The storage part 7 includes a random access memory (RAM) serving as a so-called working memory of the control processing part 2 that stores data and the like generated in execution of the predetermined programs. The storage part 7 may include a hard disk device that has a relatively large capacity.

The control processing part 2 includes a circuit that controls the parts 1, 3 to 7 of the bonded substrates misalignment amount measurement device D according to functions of the respective parts to thereby find a bonded substrates misalignment amount. The control processing part 2 includes, for example, a CPU (Central Processing Unit) and a peripheral circuitry thereof. The execution of the control processing program causes the control processing part 2 to functionally include a control section 21 and a misalignment amount calculation section 22.

The control section 21 administers the entire control of the bonded substrates misalignment amount measurement device D by controlling the parts 1, 3 to 7 of the bonded substrates misalignment amount measurement device D according to functions of the respective parts.

The misalignment amount calculation section 22 calculates a misalignment amount in the bonded substrates on the basis of a measurement result obtained by the measurement part 1. More specifically, the misalignment amount calculation section 22 calculates, for example, respective contours of the first substrate Ob1 and the second substrate Ob2 on the basis of a plurality of measurement results at a plurality of measurement locations different from one another along a circumferential direction θ of the bonded substrates Ob, and calculates a misalignment amount between the contours (for example, a distance between respective centers of the contours) as the misalignment amount. Further specifically, the misalignment amount calculation section 22 represents the measurement results at the measurement locations in polar coordinates, calculates the respective contours of the first substrate Ob1 and the second substrate Ob2 by determining circles most fitting the measurement results represented in the polar coordinates, and calculates a distance between respective centers of the contours as the misalignment amount.

For example, the transmission intensity distribution curve α of the measurement light shown in FIG. 3B can be obtained by measuring the bonded substrates Ob including the first substrate Ob1 and the second substrate Ob2 lying one on another in the thickness direction t by the measurement part 1 at one of the measurement locations as shown in FIG. 3A. Each of the first substrate Ob1 and the second substrate Ob2 is made of a material that transmits the measurement light at a certain transmittance rate. The horizontal axis in FIG. 3B represents positions in the radial direction from an emission start position of the measurement light to the bonded substrates Ob toward an outer circumferential edge, and has a coordinate origin which is an emission start position near the center of the bonded substrates Ob1. As shown in FIG. 3A, the transmission intensity distribution curve α of the measurement light has a profile showing: at the coordinate origin 0, a first transmission intensity that is a result of the transmission of the measurement light through the first substrate Ob1 and the second substrate Ob2; substantially the same constant value as the first transmission intensity at each position in the radial direction from the coordinate origin 0 to a substantially outer circumferential edge S1 of the first substrate Ob1; a sharp transmission intensity decrease to substantially zero and then a sharp transmission intensity increase up to a second transmission intensity near the outer circumferential edge S1 of the first substrate Ob1; substantially the same constant value as the second transmission intensity at each position in the radial direction from the substantially outer circumferential edge S1 of the first substrate Ob1 to a substantially outer circumferential edge S2 of the second substrate Ob2; and a sharp transmission intensity decrease to substantially zero and then a sharp transmission intensity increase up to substantially the intensity of the measurement light near the outer circumferential edge S2 of the second substrate Ob2. The second transmission intensity, which is the result of the transmission through the second substrate Ob2 only, is higher than the first transmission intensity that is the result of the transmission through both the first substrate Ob1 and the second substrate Ob2. The steep changes in the curve α near the outer circumferential edge S1 of the first substrate Ob1 and the outer circumferential edge S2 of the second substrate Ob2 are inferred to be due to the fact that the outer circumferential edge of the first substrate Ob1 and the outer circumferential edge of the second substrate Ob2 have a curved shape which is likely to scatter the measurement light to hinder the transmission of the measurement light to the light receiving section 12. Considering the curve α of the transmission intensity distribution of the measurement light has this profile, for example, the misalignment amount calculation section 22 is appreciated to calculate the substantially outer circumferential edge S1 of the first substrate Ob1 and the substantially outer circumferential edge S2 of the second substrate Ob2 by calculating two points at which the transmission intensity of the measurement light agrees with a predetermined threshold Th set in advance to determine an end portion, and calculating a middle position between the two points or a position of radially outer one of the two points.

In the case where the measurement light has a wavelength enabling transmission through the one of the first substrate Ob1 and the second substrate Ob2 of the bonded substrates Ob that has a larger diameter, and the first substrate Ob1 is made of a material that shields the measurement light, as described above, the transmission intensity has substantially the same value as the first transmission intensity "zero" at each position in the radial direction from the coordinate origin 0 to the substantially outer circumferential edge S1 of the first substrate Ob1 in FIG 3B.

Assuming that a length from a rotational center of the turntable 3 to the emission start position (coordinate origin 0) is L, a first length R1 from the rotational center of the turntable 3 to the outer circumferential edge of the first substrate Ob1 is defined in the following Equation 1, and a second length R2 from the rotational center of the turntable 3 to the outer circumferential edge of the second substrate Ob2 is defined in the following Equation 2.

$$\text{Equation 1:} \quad R1 = L + S1$$

$$\text{Equation 2:} \quad R2 = L + S2$$

Accordingly, a plurality of R1(θ) and a plurality of R2(θ) are obtained by measurement at the measurement locations different from one another along the circumferential direction θ of the bonded substrates Ob. The plurality of R1(θ) represent the contour of the first substrate Ob1, and the plurality of R2(0) represent the contour of the second substrate Ob2. FIG. 4 shows exemplary contours. At a measurement location corresponding to a position of a so-called orientation flat (flat), the length from the outer circumferential edge to the rotational center of the turntable 3 is likely to be short, and at the measurement locations on and around the flat, the value of R1(θ) is smaller (shorter) than those at the other measurement locations to form an R1(θ) line having a concavity, the value of R2(0) is smaller (shorter) than those at the other measurement locations to form an R2(θ) line having a concavity. The first substrate Ob1 is assumed to have two orientation flats, i.e., a first flat and a second flat, thus the R2(θ) line shows concavities at the two locations. Generally, a substrate has a certain radial orientation orthogonally intersecting an extending direction of the flat. Thus, a lowest position (bottom position) of the concavity corresponds to a position where a radial orientation of the substrate orthogonally intersects the extending direction of the flat.

An interval between the measurement locations in the radial direction θ is properly set in advance, and is set, for example, 0.02 [°] or the like according to the size or others of the first substrate Ob1 and the second substrate Ob2.

The turntable 3 is rotated by a motor that is pulse-controlled so as to be driven at an equiangular interval. The number of pulses required for a full rotation of the turntable is constant, and a rotational angle per pulse is thus fixed. Therefore, the control processing part 2 can perform measurement in synchronization with a constant pulse interval to thereby assure the measurement in acknowledgement of the rotational angle of the turntable 3.

The misalignment amount calculation section 22 represents the measurement results at the measurement locations in polar coordinates. The polar coordinates is a coordinate system in which a location of a point is expressed by a distance from the origin and an angle with respect to a certain orientation (reference orientation). Specifically, the measurement results R(0) showing a contour are plotted at points (θ, R(θ)). Further specifically, the measurement results are arranged in order of the radial orientation (θ - θ0) in which a certain measurement location R(θ0) among the measurement locations R(θ) is at starting point θ = 0[°]. R(0) is plotted at the point (0, R(0)), and then R(θ - θ0) are plotted at distances R(θ - θ0) in respective radial orientations (θ - 00) counter-clockwise from the X axis. Consequently, the measurement results R1(0), R2(0) shown in FIG. 4 are shown in the polar coordinates in FIG. 5. In the polar coordinates shown in FIG. 5, the X axis and the Y axis represent distances from the rotational center of the turntable 3.

Further, the misalignment amount calculation section 22 calculates a contour of the first substrate Ob1 by determining a circle most fitting the measurement results R1(θ) thus represented in the polar coordinates, and calculates a contour of the second substrate Ob2 by determining a circle most fitting the measurement results R2(0) thus represented in the polar coordinates. For example, the fitting is performed in the least squares method. More specifically, a point $(x_i, y_i)$ on a circumference of a circle having a center (a, b) and a radius c is expressed by the following Equation 3. a, b, and c are obtained in the least squares method (minimal squared error value problem in Equation 3) on the basis of the measurement results (0 - θ0, R(θ - θ0)) shown in the polar coordinates. The contours of the first substrate Ob1 and the second substrate Ob2 are thus obtained.

$$\text{Equation 3: } (x_i - a)^2 + (y_i - b)^2 = c^2$$

In the determination of the most fitting circle, the measurement results on and around the flat (i.e., the measurement results forming the concavity) are preferably excluded because they do not lie on the circumference.

Further, the misalignment amount calculation section 22 calculates a distance between the thus-calculated respective centers of the contours of the first substrate Ob1 and the second substrate Ob2 as the misalignment amount. For example, in a case where the center of the first substrate Ob1 is at $(a_1, b_1)$ and the center of the second substrate Ob2 is at $(a_2, b_2)$, a distance (the misalignment amount) PD between the respective centers is obtained by the following Equation 4.

$$\text{Equation 4: } PD = ((a_1 - a_2)^2 + (b_1 - b_2)^2)^{1/2}$$

The thus-obtained exemplary contours of the first substrate Ob1 and the second substrate Ob2 are shown in FIG. 6. In FIG. 6, the contours of the first substrate Ob1 and the second substrate Ob2 obtained as described above are coordinate-transformed so that the center of the contour of the second substrate Ob2 is at the coordinate origin $(x \leftarrow x - a_2, y \leftarrow y - b_2; a = a_1 - a_2, b = b_1 - b_2)$. Consequently, a distance (misalignment amount) PD between the respective centers is calculated as $(a^2 + b^2)^{1/2}$ $(PD = (a^2 + b^2)^{1/2})$.

Further, the control section 21 outputs from the output part 5 the misalignment amount PD of the bonded substrates obtained by the misalignment amount calculation section 22.

The control processing part 2, the input part 4, the output part 5, the IF part 6, and the storage part 7 of the bonded substrates misalignment amount measurement device D may be configured by a computer of a desktop type, a laptop type, or the like.

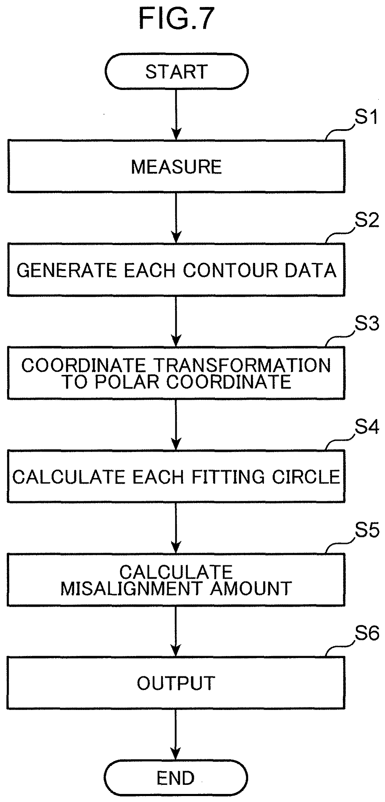

Hereinafter, an operation of the embodiment is described. FIG. 7 is the flowchart showing the operation of the bonded substrates misalignment amount measurement device.

The bonded substrates misalignment amount measurement device D configured as described above initializes necessary parts, and starts the operation when a power source thereof is turned on. The execution of the control processing program causes the control processing part 2 to functionally include the control section 21 and the misalignment amount calculation section 22.

When bonded substrates Ob to be measured is mounted on the turntable 3 by a user (operator) and the bonded substrates misalignment amount measurement device D receives an input of a measurement start, the bonded substrates misalignment amount measurement device D causes the measurement part 1 to perform measurements at certain measurement locations while causing the control section 21 of the control processing part 2 to rotate the turntable 3. Thus, transmission intensities are measured at the measurement locations different from one another along the circumferential direction θ of the bonded substrates Ob in Step S1.

Further, in Step S2, the bonded substrates misalignment amount measurement device D causes the misalignment amount calculation section 22 of the control processing part 2 to calculate respective contours of the first substrate Ob1 and the second substrate Ob2 on the basis of measurement results at the measurement locations obtained in Step S1. More specifically, the misalignment amount calculation section 22 generates R1(θ) representing a contour of the first substrate Ob1 using the Equation 1 shown above, and generates R2(0) representing a contour of the second substrate Ob2 using the Equation 2 shown above.

Further, in Step S3, the bonded substrates misalignment amount measurement device D causes the misalignment amount calculation section 22 to represent the measurement results at the measurement locations in polar coordinates. More specifically, the misalignment amount calculation section 22 plots measurement results R(0) forming a contour at respective points (θ, R(θ)).

Further, in Step S4, the bonded substrates misalignment amount measurement device D causes the misalignment amount calculation section 22 to calculate the respective contours of the first substrate Ob1 and the second substrate Ob2 by determining circles most fitting the measurement results R1(θ), R2(0) represented in the polar coordinates.

Further, in Step S5, the bonded substrates misalignment amount measurement device D causes the misalignment amount calculation section 22 to calculate a distance between respective centers of the thus-calculated contours of the first substrate Ob1 and the second substrate Ob2 as the misalignment amount PD.

Further, the bonded substrates misalignment amount measurement device D causes the control section 21 of the control processing part 2 to output from the output part 5 the thus-calculated misalignment amount PD in Step S6, and ends the process. Alternatively, the bonded substrates misalignment amount measurement device D may output the misalignment amount calculated in Step S5 to an external device via the IF part 6, if necessary.

As described above, the bonded substrates misalignment amount measurement device D and the bonded substrates misalignment amount measurement method performed by the device according to the embodiment eliminate the need for the edge end position measurement means (the edge shape measurement means 4 as an example thereof) of the bonded substrates misalignment detection device disclosed in Patent Literature 1. The bonded substrates misalignment amount measurement device measures a transmission intensity distribution of measurement light in a radial direction by a measurement light having a wavelength enabling transmission through one of the first substrate and the second substrate that has a larger diameter. Thus, the bonded substrates misalignment amount measurement device can calculate an end portion (outer circumferential edge end portion) of the first substrate and an end portion (outer circumferential edge end portion) of the second substrate instead of an end portion of a combination of the first and second substrates calculated by the outermost edge measurement means (the contour measurement means 3 as an example thereof) of bonded substrates misalignment detection device disclosed in Patent Literature 1. Therefore, the bonded substrates misalignment amount measurement device D and the bonded substrates misalignment amount measurement method can suppress an increase in size of the entire device and an increase in amount of information to be processed.

The bonded substrates misalignment amount measurement device D and the bonded substrates misalignment amount measurement method execute a relative movement in the circumferential direction between the light emitting section 11 and the light receiving section 12 and the bonded substrates Ob. Thus, the bonded substrates misalignment amount measurement device D and the bonded substrates misalignment amount measurement method can measure a transmission intensity distribution of the measurement light in the radial direction at the measurement locations different from one another along the circumferential direction.

The bonded substrates misalignment amount measurement device D and the bonded substrates misalignment amount measurement method represent the measurement results R(θ) at the measurement locations different from one another along the circumferential direction θ in polar coordinates. Thus, the bonded substrates misalignment amount measurement device D and the bonded substrates misalignment amount measurement method can simplify the calculation to obtain a contour. The bonded substrates misalignment amount measurement device D and the bonded substrates misalignment amount measurement method determine the most fitting circles as the contours. Thus, the bonded substrates misalignment amount measurement device D and the bonded substrates misalignment amount measurement method can more accurately calculate the misalignment amount.

In this embodiment, a bonded substrates misalignment amount measurement device D and a bonded substrates misalignment amount measurement method that calculate a distance between respective centers of contours of the first substrate Ob1 and the second substrate Ob2 as the misalignment amount can be provided.

The bonded substrates misalignment amount measurement device D according to the embodiment may be used in a proper semiconductor manufacturing apparatus. For example, as disclosed in Patent Literature 1, the semiconductor manufacturing apparatus forms a semiconductor element (pellet) on bonded substrates Ob. Correction of a element forming position on the bonded substrates Ob according to a misalignment amount measured by the bonded substrates misalignment amount measurement device D enables element formation at a correct position in consideration of the bonding misalignment. Alternatively, for example, as disclosed in Japanese Unexamined Patent Publication No. 2005-005318, a semiconductor apparatus is a bonding apparatus that manufactures bonded substrates. Correction of a bonding position according to a misalignment amount measured by the bonded substrates misalignment amount measurement device D enables manufacture of more favorable bonded substrates. For example, the bonding apparatus includes a pressing plate that aligns a pair of stacked wafers by pressing the wafers in a horizontal direction (in a direction over a horizontal plane, the direction being normal to a thickness direction). The bonding apparatus may manufacture the bonded substrates by measuring a misalignment amount by the bonded substrates misalignment amount measurement device D before the alignment, and performing the alignment by controlling the operation of the pressing plate according to the measured misalignment amount. Alternatively, for example, it may be appreciated that bonded substrates manufactured by the bonding apparatus is used as a sample, a misalignment amount in the bonded substrates is measured by the bonded substrates misalignment amount measurement device D, and the bonded substrates is manufactured after adjusting the operation of the pressing plate according to the measured misalignment amount. Alternatively, for example, as disclosed in Japanese Patent No. 6916877. the semiconductor apparatus is a chemical mechanical polishing machine (CMP machine) that polishes wafers. When the misalignment amount measured by the bonded substrates misalignment amount measurement device D is large (when the misalignment amount exceeds a threshold set in advance), the bonded substrates may be removed from a production line so as not to be polished by the CMP machine. This can keep the bonded substrates from causing a problem during the manufacture.

The present specification has disclosed technologies having various aspects as described above, and main technologies are summarized hereinafter.

A bonded substrates misalignment amount measurement device according to an aspect is for measuring a misalignment amount between two sorts of disc-shaped substrates having different diameter from one another and including a first substrate and a second substrate lying one on another in a thickness direction thereof, and includes: a measurement part that emits measurement light to the bonded substrates in the thickness direction to thereby measure a transmission intensity distribution of the measurement light in a radial direction thereof; and a misalignment amount calculation part that calculates a misalignment amount on the basis of a measurement result obtained by the measurement part, wherein the measurement light has a wavelength enabling transmission through the one of the first substrate and the second substrate that has a larger diameter. Preferably, in the bonded substrates misalignment amount measurement device, the misalignment amount may be a distance between respective centers of the first substrate and the second substrate. Preferably, in the bonded substrates misalignment amount measurement device, it may be appreciated that the measurement part measures a transmission intensity distribution at a plurality of measurement locations different from one another along the circumferential direction, and the misalignment amount calculation part calculates respective contours of the first substrate and the second substrate on the basis of a plurality of measurement results at the measurement locations, and calculates a misalignment amount between the contours as the misalignment amount. Preferably, in the bonded substrates misalignment amount measurement device, a transmittance rate of the bonded substrates for the light having a wavelength enabling transmission may be a value allowing the measurement part to obtain a significant transmission intensity. Preferably, in the bonded substrates misalignment amount measurement device, a transmittance rate of the bonded substrates for the light having a wavelength enabling transmission may not be zero.

The bonded substrates misalignment amount measurement device eliminates the need for the edge end position measurement means (the edge shape measurement means 4 as an example thereof) of the bonded substrates misalignment detection device disclosed in Patent Literature 1. The bonded substrates misalignment amount measurement device measures a transmission intensity of measurement light in a radial direction by a measurement light having a wavelength enabling transmission through one of the first substrate and the second substrate that has a larger diameter. Thus, the bonded substrates misalignment amount measurement device can calculate an end portion (outer circumferential edge end portion) of the first substrate and an end portion (outer circumferential edge end portion) of the second substrate instead of an end portion of a combination of the first and second substrates calculated by the outermost edge measurement means (the contour measurement means 3 as an example thereof) of the bonded substrates misalignment detection device disclosed in Patent Literature 1. Therefore, the bonded substrates misalignment amount measurement device can suppress an increase in size of the entire device and an increase in amount of information to be processed.

It should be noted that in the specification, one or both of the substrates may be a multilayer substrate, and "two sorts" is thus used instead of "two pieces".

In another aspect, in the bonded substrates misalignment amount measurement device, the measurement part may include a light emitting section that emits the measurement light to the bonded substrates in the thickness direction along a line extending in the radial direction, and a light receiving section facing the light emitting section, and the bonded substrates misalignment amount measurement device may further include a moving mechanism that executes a relative movement in a circumferential direction between the light emitting section and the light receiving section and the bonded substrates placed between the light emitting section and the light receiving section.

The bonded substrates misalignment amount measurement device executes the relative movement in the circumferential direction between the light emitting section and the light receiving section and the bonded substrates. Thus, the bonded substrates misalignment amount measurement device can measure a transmission intensity distribution of the measurement light in the radial direction at the measurement locations different from one another along the circumferential direction.

In still another aspect, in the bonded substrates misalignment amount measurement device, it may be appreciated that the misalignment amount calculation part calculates respective contours of the first substrate and the second substrate on the basis of the measurement result obtained by the measurement part, and calculates a distance between respective centers of the contours as the misalignment amount.

Thus, the bonded substrates misalignment amount measurement device that calculates a distance between respective centers of contours of the first substrate and the second substrate as the misalignment amount can be provided.

In still another aspect, in the bonded substrates misalignment amount measurement device, it may be appreciated that the measurement part measures a transmission intensity distribution at a plurality of measurement locations different from one another along the circumferential direction, and the misalignment amount calculation part represents a plurality of measurement results at the measurement locations in a polar coordinate, calculates the respective contours of the first substrate and the second substrate by determining circles most fitting the measurement results represented in the polar coordinate, and calculates a distance between respective centers of the contours as the misalignment amount.

The bonded substrates misalignment amount measurement device represents the measurement results at the measurement locations different from one another along the circumferential direction in polar coordinates. Thus, the bonded substrates misalignment amount measurement device can simplify the calculation to obtain a contour. The bonded substrates misalignment amount measurement device determines the most fitting circles as the contours. Thus, the bonded substrates misalignment amount measurement device can more accurately calculate the misalignment amount.

In still another aspect, the bonded substrates misalignment amount measurement method measures a misalignment amount between two sorts of disc-shaped substrates having different diameter from one another and including a first substrate and a second substrate lying one on another in a thickness direction thereof, and includes: a measurement step of emitting measurement light to the bonded substrates in the thickness direction to thereby measure a transmission intensity distribution of the measurement light in a radial direction thereof; and a misalignment amount calculation step of calculating a misalignment amount on the basis of a measurement result obtained in the measurement step, wherein the measurement light has a wavelength enabling transmission through the one of the first substrate and the second substrate that has a larger diameter.

The bonded substrates misalignment amount measurement method produces the same advantageous effect as the bonded substrates misalignment amount measurement device, and can suppress an increase in size of the entire device and an increase in amount of information to be processed.

A semiconductor manufacturing apparatus according to still another aspect of the present invention includes any one of the bonded substrates misalignment amount measurement devices described above.

Thus, the semiconductor manufacturing apparatus by use of the bonded substrates misalignment amount measurement device can be provided.

This application is based on Japanese Patent Application No. 2023-40047 filed on March 14, 2023, the contents of which are incorporated in the present application.

Although the present invention has been fully described by way of example with reference to the accompanying drawings, it is to be understood that various changes and modifications will be apparent to those skilled in the art. Therefore, unless otherwise such changes and modifications depart from the scope of the present invention hereinafter defined, they should be construed as being included therein.

**Industrial Applicability**

The present invention can provide a bonded substrates misalignment amount measurement device and a misalignment amount measurement method for measuring a misalignment amount between two sorts of bonded substrates lying one on another in a thickness direction, and a semiconductor manufacturing apparatus by use of the bonded substrates misalignment amount measurement device.

**Claims**

1. A bonded substrates misalignment amount measurement device for measuring a misalignment amount between two sorts of disc-shaped substrates having different diameter from one another and including a first substrate and a second substrate lying one on another in a thickness direction thereof, comprising:

   a measurement part that emits measurement light to the bonded substrates in the thickness direction to thereby measure a transmission intensity distribution of the measurement light in a radial direction thereof; and
   a misalignment amount calculation part that calculates a misalignment amount on the basis of a measurement result obtained by the measurement part, wherein
   the measurement light has a wavelength enabling transmission through the one of the first substrate and the second substrate that has a larger diameter.

2. The bonded substrates misalignment amount measurement device according to claim 1,wherein

   the measurement part includes a light emitting section that emits the measurement light to the bonded substrates in the thickness direction along a line extending in the radial direction, and a light receiving section facing the light emitting section,
   further comprising:
   a moving mechanism that executes a relative movement in a circumferential direction between the light emitting section and the light receiving section and the bonded substrates placed between the light emitting section and the light receiving section.

3. The bonded substrates misalignment amount measurement device according to claim 1, wherein
   the misalignment amount calculation part calculates respective contours of the first substrate and the second substrate on the basis of the measurement result obtained by the measurement part, and calculates a distance between respective centers of the contours as the misalignment amount.

4. The bonded substrates misalignment amount measurement device according to claim 1, wherein

   the measurement part measures a transmission intensity distribution at a plurality of measurement locations different from one another along the circumferential direction, and
   the misalignment amount calculation part represents a plurality of measurement results at the measurement locations in a polar coordinate, calculates the respective contours of the first substrate and the second substrate by determining circles most fitting the measurement results represented in the polar coordinate, and calculates a distance between respective centers of the contours as the misalignment amount.

5. A bonded substrates misalignment amount measurement method for measuring a misalignment amount between two sorts of disc-shaped substrates having different diameter from one another and including a first substrate and a second substrate lying one on another in a thickness direction thereof, comprising:

   a measurement step of emitting measurement light to the bonded substrates in the thickness direction to thereby measure a transmission intensity distribution of the measurement light in a radial direction thereof; and
   a misalignment amount calculation step of calculating a misalignment amount on the basis of a measurement result obtained in the measurement step, wherein
   the measurement light has a wavelength enabling transmission through the one of the first substrate and the second substrate that has a larger diameter.

6. A semiconductor manufacturing apparatus including $\alpha$ bonded substrates misalignment amount measurement device according to any one of claims 1 to 4.

EP 4 657 010 A1

FIG.1

# FIG.2

FIG.3A

FIG.3B

STEEP CHANGE IN
TRANSMISSION LIGHT INTENSITY

TRANSMISSION INTENSITY

THRESHOLD

0

S1

S2

RADIAL DIRECTION

α

# FIG.4

FIG.5

FIRST FLAT

SECOND FLAT

SP2

SP1

θ

FIG.6

CP2(SECOND
SUBSTRATE CENTER)

Y

(a,b)

X

CP1
(FIRST
SUBSTRATE
CENTER)

# FIG.7

START

↓

MEASURE — S1

↓

GENERATE EACH CONTOUR DATA — S2

↓

COORDINATE TRANSFORMATION
TO POLAR COORDINATE — S3

↓

CALCULATE EACH FITTING CIRCLE — S4

↓

CALCULATE
MISALIGNMENT AMOUNT — S5

↓

OUTPUT — S6

↓

END

## INTERNATIONAL SEARCH REPORT

| International application No. |
|---|
| **PCT/JP2024/005539** |

**A. CLASSIFICATION OF SUBJECT MATTER**

*G01B 11/00*(2006.01)i; *H01L 21/02*(2006.01)i
FI:  G01B11/00 C; H01L21/02 B

According to International Patent Classification (IPC) or to both national classification and IPC

**B. FIELDS SEARCHED**

Minimum documentation searched (classification system followed by classification symbols)

G01B11/00; H01L21/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-269915 A (NITTO DENKO CORPORATION) 05 October 2006 (2006-10-05) paragraphs [0001]-[0085], fig. 1-16 | 1-6 |
| Y | WO 2019/064367 A1 (SHARP KABUSHIKI KAISHA) 04 April 2019 (2019-04-04) paragraphs [0038]-[0061], fig. 7-11 | 1-6 |
| Y | JP 2010-54377 A (CCS INC.) 11 March 2010 (2010-03-11) paragraphs [0001]-[0048], fig. 1-5 | 1-6 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **12 April 2024** | **23 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/005539**

| Patent document cited in search report | | | Publication date (day/month/year) | Patent family member(s) | Publication date (day/month/year) |
|---|---|---|---|---|---|
| JP | 2006-269915 | A | 05 October 2006 | (Family: none) | |
| WO | 2019/064367 | A1 | 04 April 2019 | US 2020/0091467 A1 paragraphs [0053]-[0076], fig. 7-11 | |
| JP | 2010-54377 | A | 11 March 2010 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5373707 B
- JP 2005005318 A
- JP 6916877 B
- JP 2023040047 A